# EUROPÄISCHE PATENTSCHRIFT

(11) **EP 0 596 566 B1**
(45) Veröffentlichungstag und Bekanntmachung des Hinweises auf die Patenterteilung: **24.07.1996**
(21) Anmeldenummer: 93203018.2
(22) Anmeldetag: 28.10.1993
(51) Int. Cl.: H02H 7/045, H02H 7/04, G01R 33/032

(54) **Hochspannungstransformator**
High-voltage transformer
Transformateur H.T.

(30) Priorität: 28.10.1992 DE 4236378
(43) Veröffentlichungstag der Anmeldung: 11.05.1994
(73) Patentinhaber: Schorch GmbH, D-41236 Mönchengladbach (DE)
(72) Erfinder: Veit, Karl Boromäus, D-30974 Wennigsen (DE); Weber, Walter, D-41189 Mönchengladbach (DE)
(74) Vertreter: Cohausz & Florack

(56) Entgegenhaltungen:
- AT-B- 250 478
- AT-B- 278 139
- DE-A- 3 431 769

## Beschreibung

Die Erfindung betrifft einen Hochspannungstransformator.

Aus der Asea-Zeitschrift 1980, Seite 3 bis 10 ist ein Hochspannungstransformator bekannt, dessen Primär- und Sekundärwicklungsanschlüsse jeweils über Durchführungen an äußere Anschlußpunkte geführt sind. Ebenso ist es bekannt (DE-GM 75 22 858), Meßmittel zur Bestimmung der primärseitigen und sekundärseitigen Stromstärke vorzusehen, die einer Auswerteeinrichung derart zugeordnet sind, daß, wenn das Verhältnis der Stromstärken nicht dem Kehrwert des Übersetzungsverhältnisses des Transformators entspricht, die Abweichung zur Auslösung von dem Transformator primär- und sekundärseitig vorgeordneten Leistungsschaltern herangezogen wird.

Zur Vermeidung von Folgeschäden ist bei Hochspannungstransformatoren bei einem inneren Fehler eine Schnellabschaltung erforderlich.

Hierzu sind Stromwandler vorgesehen, die jeweils den Primär- bzw. Sekundärstrom messen, sowie eine Auswerteeinrichtung, die aus der Differenz ihrer Ausgangssignale eine Auslösung von Leistungsschaltern im Primär- bzw. Sekundärstromkreislauf bewirkt.

In einer ersten Variante ist dabei im Stand der Technik vorgesehen, herkömmliche Stromwandler in der Schaltanlage vorzusehen, die außerhalb des Hochspannungstransformators angeordnet sind.

Solche herkömmliche Stromwandler weisen den Nachteil auf, daß sie einen erheblichen Platzbedarf in der Schaltanlage benötigen und ein zusätzliches Gefahrenprotential darstellen. Desweiteren ist hierfür ein hoher Investitionsaufwand erforderlich.

In einer anderen Variante ist es aus dem Stand der Technik bekannt, die Meßmittel zur Bestimmung der primärseitigen und sekundärseitigen Stromstärke als Ringstromwandler auszuführen, welcher zwischen den Durchführungen und den Transformatorwicklungen angeordnet ist. Diese Ausführung erlaubt eine einfache meßtechnische Anordnung, hat aber den Nachteil, daß Störungen im Stromverlauf, die im Bereich der Durchführungen erfolgen, von den Wandlern nicht erfaßt werden, so daß es hierdurch zu Zerstörungen des Transformators kommen kann, da der Bereich der Durchführungen nicht in den Überwachungsbereich der Sicherungseinrichtungen miteinbezogen ist.

Aus der DE-OS 3431769 ist es bekannt, einen faseroptischen Stromsensor für Schutzzwecke vorzusehen, welcher aus Lichtleitfasern besteht, die in der Nähe einer stromführenden Hochspannungsleitung angeordnet sind.

Der Erfindung liegt die Aufgabe zugrunde, einen Hochspannungstransformator dahingehend weiterzuentwickeln, daß sein Aufbau kostengünstiger und hinsichtlich der Sicherheit verbessert wird. Diese Aufgabe wird erfindungsgemäß durch die Merkmale des Anspruchs 1 gelöst.

Die Erfindung zeichnet sich dadurch aus, daß es durch die Ausgestaltung der Mittel zur Bestimmung der Stromstärken als elektrooptische Stromsensoren möglich ist, diese innerhalb einer jeweiligen Durchführung als integrierte Baueinheit anzuordnen. Hierdurch wird ermöglicht, daß auch der Bereich der Durchführungen hinsichtlich des Stromes überwacht wird, so daß auch durch dort auftretende Fehler die Sicherungseinrichtungen ausgelöst werden. Hierbei wird die raumsparende Anordnung der elektrooptischen Stromsensoren ausgenutzt. Insbesondere sind diese Sensoren für die Stromüberwachung geeignet, da sie wegen der Verwendung von Lichtleitern galvanisch entkoppelt sind und Einstreuungen durch elektromagnetische Felder vermieden werden. Dies ist insbesondere bei Höchstspannungstransformatoren ein erheblicher Vorteil gegenüber herkömmlichen Stromwandlern. Andererseits kann durch die Übertragung des Ausgangssignals der elektrooptischen Stromsensoren über Lichtleiter der Herausführungspunkt des Stromsignals praktisch beliebig vorgegeben werden, da ungewollte Beeinflussungen des Meßsignals durch die Transformatorströme nicht stattfinden.

In einer bevorzugten Ausführungsform der Erfindung ist vorgesehen, daß die Lichtleiter jedes Stromsensors innerhalb der zugeordneten Durchführung in den Bereich zwischen Durchführung und dem zugehörigen Wicklungsanschluß geführt sind. Insbesondere ist vorgesehen, den Lichtleiter aus der Durchführung in der Nähe des Durchführungsflansches herauszuleiten. Hierdurch läßt sich eine zweckmäßige und störungsfreie Möglichkeit schaffen, die Auswerteeeinrichtung anzuschließen. Die der Auswerteeinrichtung nachgeordneten Elemente können gegenüber der bisherigen Lösung unverändert bleiben.

In einer weiteren Ausgestaltung der Erfindung ist vorgesehen, daß den Stromsensoren jeweils weitere elektrooptische Wandler als Spannungssensoren zugeordnet sind. Neben der Strommessung kann somit auch eine Spannungsmessung erfolgen, die ebenfalls den Vorteil hat, daß sie unbeeinflußt von durch die Höchstspannung des Transformators hervorgerufenen Störungen ablaufen kann.

Die Erfindung betrifft als weitere bevorzugte Ausführungsform einen Hochspannungstransformator der eingangs genannten Art, welcher zusätzlich jeweils zwischen den den äußeren Anschlußpunkten benachbarten Bereichen der Durchführungen und Erdpotential geschaltete Überspannungsableiter aufweist. Um auch eventuelle an dem Überspannungsableitern auftretende Fehler mit in den Überwachungsprozeß einzubeziehen, sieht die Erfindung zusätzlich vor, daß der dem äußeren Anschlußpunkt benachbarte Bereich der Durchführung von einem Gehäuse umgeben ist, welches eine isolierende Eintrittsöffnung für den in die Durchführung (4) führenden Stromleiter aufweist, wobei der Überspannungsableiter (18) leitend mit dem Gehäusemantel verbunden und der Gehäusemantel an einer zwischen Stromsensor und Durchführung liegenden Stelle leitend mit dem Stromleiter verbunden ist.

Auf diese Weise wird ein Strom, der von den äußeren Anschlußpunkten kommt und über den Überspannungsleiter abfließt, vom Sensor mit erfaßt.

Eine hierzu äquivalente Lösung sieht vor, daß der dem äußeren Anschlußpunkt benachbarte Bereich der Durchführung von einem Gehäuse umgeben ist, welches eine leitend mit dem Gehäusemantel verbundene Eintrittsöffnung für den in die Durchführung führenden Stromleiter aufweist, wobei der Überspannungsableiter durch eine isolierende Durchführung im Gehäusemantel hindurch geführt ist und an einer zwischen Stromsensor und Durchführung liegenden Stelle leitend mit dem Stromleiter verbunden ist.

Die Erfindung wird nun anhand einer Zeichnung näher erläutert:

Hierbei zeigen:
- Fig. 1: ein Blockschaltbild einer ersten, aus dem Stand der Technik bekannten Ausführungsform eines Hochspannungstransformators,
- Fig. 2: ein zweites Ausführungsbeispiel eines aus dem Stand der Technik bekannten Hochspannungstransformators und
- Fig. 3: ein Blockschaltbild des erfindungsgemäßen Hochspannungstransformators.
- Fig. 4: einen Ausschnitt aus Fig. 3,
- Fig. 5: eine Alternative zu der Lösung nach Fig. 4.

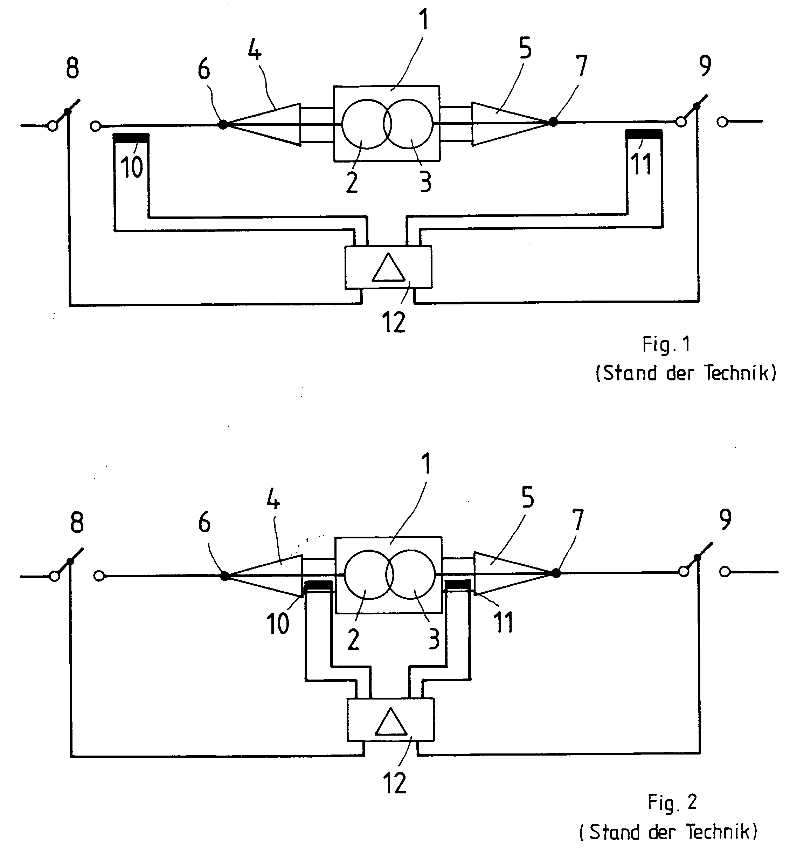

Bezugnehmend auf Fig. 1 besteht der Hochspannungstransformator im wesentlichen aus seiner Primärwicklung 2, seiner Sekundärwicklung 3 und jeweils einer Wicklung zugeordneten Durchführungen 4,5, mit einem jeweiligen äußeren Anschlußpunkt 6,7, über den die Ströme vom Transformator 1 in die Schaltanlage übertragen werden.

Außerhalb der äußeren Anschlußpunkte sind sowohl primärseitig als auch sekundärseitig Leistungsschalter 8,9 vorgesehen, die von einer im folgenden dargestellten Meßeinrichtung ausgelöst werden, wenn das Verhältnis Stromstärken nicht dem Kehrwert des Übersetzungsverhältnisses des Transformators entspricht.

Die Erfassung der Ströme aus der Primär- bzw. Sekundärseite erfolgt nach dem Ausführungsbeispiel aus Fig. 1 über herkömmliche Stromwandler 10,11, deren Ausgangssignale jeweils in eine Auswerteeinrichtung 12 eingespeist werden, welche aus beiden Eingangssignalen ein Differenzsignal bildet. Weichen unter Berücksichtigung des Übersetzungsverhältnisses des Hochspannungstransformators 1 die Stromstärken in Sekundär- bzw. Primärseite voneinander ab, gibt die Auswerteeinrichtung 12 ein Signal an die Leistungsschalter 8,9, so daß diese sofort abschalten und den Hochspannungstransformator vor weiterer Stromzuführung schützen.

Das in Fig. 2 dargestellte Ausführungsbeispiel unterscheidet sich von dem ersten dadurch, daß die Stromwandler nicht wie in Fig. 1 außerhalb der äußeren Anschlußpunkte 6,7 angeordnet sind, sondern im Transformator zwischen der jeweiligen Wicklung und der zugehörigen Durchführung, also im sogenannten Dom des Transformators angeordnet sind.

Darüber hinaus sind gemäß Fig. 2 keine getrennten herkömmlichen Stromwandler vorgesehen sondern Ringstromwandler.

Hinsichtlich der Funktion unterscheidet sich die Ausführung nach Fig. 2 von derjenigen nach Fig. 1 dadurch, daß bei der Anordnung der Stromwandler innerhalb des Transformators nur diejenigen Ströme erfaßt werden können, die unmittelbar im Wicklungsbereich auftreten, während Ströme im Bereich der Durchführungen nicht erfaßt werden.

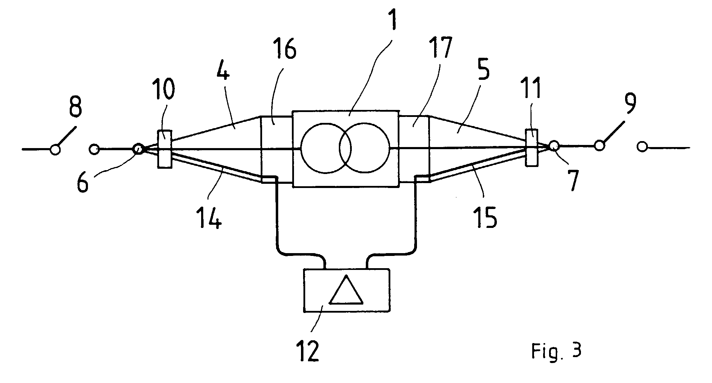

Das in Fig. 3 dargestellte Ausführungsbeispiel der erfindungsgemäßen Vorrichtung entspricht im Bezug auf die übereinstimmenden Bezugszeichen den dargestellten Figuren 1 und 2.

Im Unterschied zum Stand der Technik ist bei der erfindungsgemäßen Anordnung jedoch vorgesehen, daß die Stromwandler als elektrooptische Stromsensoren 10,11 ausgeführt sind, die in dem den äußeren Anschlußpunkten 6,7 benachbarten Bereich der Durchführungen 4,5, angeordnet sind. Die Ausgangssignale der Stromsensoren 10,11 werden mittels Lichtleitern 14,15 übertragen, welche von den Stromsensoren 10,11 ausgehend innerhalb der jeweiligen Durchführungen 4,5 verlegt sind und in die zugehörigen Dom-Bereiche 16,17 führen, die jeweils zwischen Durchführung 4,5 und zugeordneter Hochspannungswicklung 2,3 angeordnet sind. Aus dem Dom-Bereich 16,17 wird das jeweilige Stromsignal über den Lichtleiter auf die Auswerteeinrichtung 12 übertragen. Alternativ ist vorgesehen, den Lichtleiter aus der Durchführung in der Nähe des Durchführungsflansches herauszuleiten.

Die Funktion der elektrooptischen Stromsensoren ist im Prinzip aus der DE-OS 3431769 bekannt. Solche Stromsensoren nutzen den Faraday-Effekt aus, gemäß dem in bestimmten lichtleitenden Materialien die Polarisationsebene eines linearpolarisierten Lichtstrahls unter dem Einfluß eines Magnetfeldes, welches sich entlang des Lichtstrahles erstreckt, um eine Achse gedreht wird, die parallel zum Lichtstrahl verläuft. Das Ausmaß der Drehung der Polarisationsebene ist dabei proportional zur Größe des magnetischen Feldes, welches wiederum proportional zur elektrischen Stromstärke ist.

Durch die erfindungsgemäße Anordnung der elektrooptischen Stromsensoren im Randbereich der Durchführungen lassen sich auch solche Störungen mit überwachen, die nach dem in Fig. 2 dargestellten Ausführungsbeispiel zu von Folgeschäden bei einem inneren Fehler des Hochspannungstransformators sowie seiner Durchführungen geführt hätten.

Die Sensoreinheit gebildet durch den elektrooptischen Wandler und den Lichtleiter läßt sich an bestehenden Hochspannungstransformatoren leicht nachrüsten, wobei die Anschlußpunkte in den jeweiligen Domen zur Herausführung des Meßsignals in die Auswerteeinrichtung 12, die beim aus dem Stand der Technik bekannten Hochspannungstransformator bereits vorhanden sind, ausgenutzt werden können.

Darüber hinaus ist es möglich, nicht nur die Stromstärke am Ort des Sensors zu messen sondern auch unter Verwendung eines weiteren elektrooptischen Wandlers den Wert der Hochspannung an dieser Stelle.

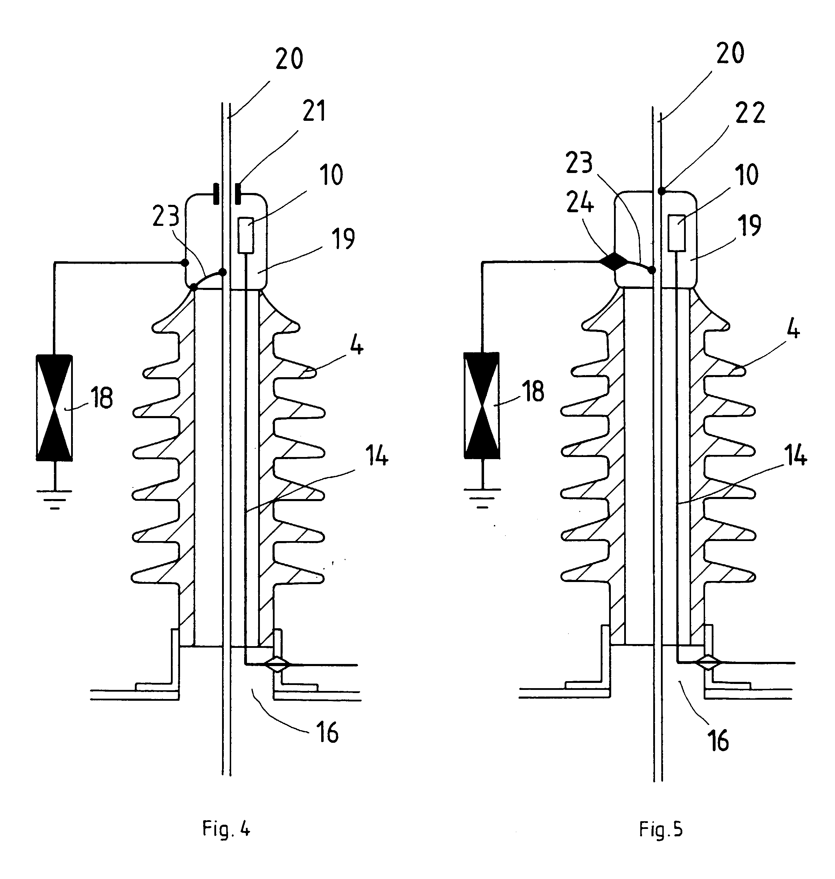

Die in den Figuren 4 und 5 dargestellten Varianten erlauben in Ergänzung des in Fig. 3 dargestellten Ausführungsbeispiels auch die Überwachung von solchen Fehlern, die durch Überspannungsableiter bedingt sein können, die zwischen dem den äußeren Anschlußpunkten benachbarten Bereich der Durchführungen, also dem sogenannten "Kopf" der Durchführungen und Erdpotential angeordnet sind. Die Figuren 4 und 5 zeigen hierzu einen Ausschnitt aus Fig. 3 im Bereich der dort links dargestellten Durchführung 4 bzw. deren Kopf, in dem der Stromsensor 10 untergebracht ist. Der "Dom" 16 ist in den Figuren 4 und 5 nur skizziert angedeutet.

Wie aus Fig. 4 hervorgeht, befindet sich in dem den Stromwandler 10 umgebenden Bereich am Durchführungskopf ein Gehäuse 19, dessen Mantel im oberen Bereich, d.h., in dem Bereich, in dem ein Stromleiter 20 von den äußeren Anschlußpunkten in die Durchführung 4 hineingeführt wird, isolierend ausgebildet ist. Der Überspannungsableiter 18 ist mit dem Gehäusemantel leitend verbunden. Zwischen dem Gehäusemantel und dem Stromleiter 20 befindet sich eine leitende Verbindung 23, die an einem solchen Ort positioniert ist, der zwischen der Position des Stromwandlers 10 und dem Beginn der Durchführung 4 liegt.

Auf diese Weise wird ermöglicht, daß ein vom Stromleiter 20 in den Überspannungsableiter 18 fließender Strom vom Stromwander 10 mit erfaßt wird, so daß evtl. durch den Überspannungswandler 18 bedingte Störungen mit in den Überwachungskreis einbezogen werden können.

Eine hierzu äquivalente Ausgestaltung ist in Fig. 5 dargestellt. Hier ist die Eintrittsöffnung des Gehäusemantels nicht wie in Fig. 4 isolierend gegenüber dem Stromleiter 20 ausgeführt sondern leitend mit diesem verbunden. Der Anschlußpunkt des Überspannungsableiters 18 aber durch eine isolierende Durchführung 24 durch den Gehäusemantel geführt und wiederum an einer Stelle, die zwischen dem Stromwandler 10 und dem Beginn der Durchführung 4 liegt, leitend mit dem Stromleiter 20 kontaktiert. Hierdurch ist ebenfalls gewährleistet, daß der in den Überspannungsableiter 18 einfließende Strom vom Stromwandler 10 erfaßt wird.

## Patentansprüche

1. Hochspannungstransformator bestehend aus folgenden Merkmalen:
- die Primär- und Sekundärwicklungsanschlüsse (2,3) sind jeweils über Durchführungen (4,5) an äußere Anschlußpunkte (6,7) geführt,
- Meßmittel (10,11,12) zur Bestimmung der primärseitigen und sekundärseitigen Stromstärke sind vorgegeben,
- die Meßmittel sind einer Auswerteeinrichtung (12) derart zugeordnet, daß, wenn das Verhältnis der Stromstärken nicht dem Kehrwert des Übersetzungsverhältnisses des Transformators entspricht, die Abweichung zur Auslösung von dem Transformator primär- und sekundärseitig vorgeordneten Leistungsschaltern (8,9) herangezogen wird,
- die Meßmittel zur Bestimmung der Stromstärken sind zwei elektrooptische Stromsensoren (10,11), die jeweils in dem den äußeren Anschlußpunkten (6,7) benachbarten Bereich der Durchführung (4,5) angeordnet sind,
- das Ausgangssignal des jeweiligen elektrooptischen Stromsensors (10,11) ist mittels Lichtleiter (14,15) in die Auswerteeinrichtung (12) übertragbar.

2. Hochspannungstransformator nach Anspruch 1,
**dadurch gekennzeichnet**, daß die Lichtleiter (14,15) jedes Stromsensors (10,11) innerhalb der zugeordneten Durchführung (4,5) in den Bereich zwischen Durchführung und dem zugehörigen Wicklungsanschluß (2,3) geführt sind.

3. Hochspannungstransformator nach Anspruch 1 oder 2,
**dadurch gekennzeichnet**, daß den Stromsensoren (10,11) jeweils weitere elektrooptische Wandler als Spannungssensoren zugeordnet sind.

4. Hochspannungstransformator nach einem der vorhergehenden Ansprüche, wobei den äußeren Anschlußpunkten (6,7) jeweils zwischen dem benachbarten Bereich der Durchführungen und Erdpotential geschaltete Überspannungsableiter (18) zugeordnet sind,
**dadurch gekennzeichnet**, daß der dem äußeren Anschlußpunkt (6,7) benachbarte Bereich der Durchführung (4,5) von einem Gehäuse (19) umgeben ist, welches eine isolierende Eintrittsöffnung (21) für den in die Durchführung (4) führenden Stromleiter (20) aufweist, wobei der Überspannungsableiter (18) leitend mit dem Gehäusemantel verbunden und der Gehäusemantel an einer zwischen Stromsensor (10) und Durchführung (4) liegenden Stelle leitend mit dem Stromleiter verbunden ist.

5. Hochspannungstransformator nach einem der vorhergehenden Ansprüche, wobei den äußeren Anschlußpunkten (6,7) jeweils zwischen dem benachbarten Bereich der Durchführungen und Erdpotential geschaltete Überspannungsableiter (18) zugeordnet sind,
**dadurch gekennzeichnet**, daß der dem äußeren Anschlußpunkt (6,7) benachbarte Bereich der Durchführung (4,5) von einem Gehäuse (19) umgeben ist, welches eine leitend mit dem Gehäusemantel verbundene Eintrittsöffnung (22) für den in die Durchführung (4) führenden Stromleiter (20) aufweist, wobei der Überspannungsableiter (18) durch eine isolierende Durchführung (24) im Gehäusemantel hindurch geführt ist und an einer zwischen Stromsensor (10) und Durchführung (4) liegenden Stelle leitend mit dem Stromleiter (20) verbunden ist.

## Claims

1. A high voltage transformer comprising the following features:
- the primary and secondary winding connections (2, 3) each extend via bushings (4, 5) to external connectors (6, 7),
- measuring means (10, 11, 12) are provided for determining the primary side and secondary side current intensity,
- the measuring means are so associated with an evaluating device (12) that if the ratio of the current intensities does not correspond to the reciprocal value of the voltage ratio of the transformers, the deviation is used for triggering power switches (8, 9) connected to the transformer on the primary and secondary sides,
- the measuring means for determining the current intensities are two electro-optical current sensors (10, 11) which are each disposed in the zone of the bushing (4, 5) adjacent the external connectors (6, 7),
- the output signal of each electro-optical current sensor (10, 11) can be transmitted via optical fibre cables (14, 15) to the evaluating device (12).

2. A high voltage transformer according to claim 1, characterized in that the optical fibre cables (14, 15) of each current sensor (10, 11) extend inside the associated bushing (4, 5) into the zone between the bushing and the associated winding connection (2, 3).

3. A high voltage transformer according to claims 1 or 2, characterized in that further electro-optical transducers are associated as voltage sensors with each of the current sensors (10, 11).

4. A high voltage transformer according to one of the preceding claims, wherein lightening arresters (18) connected between the zone adjacent to the bushings and earth potential are associated with each of the external connectors (6, 7), characterized in that the zone of the bushing (4, 5) adjacent the external connectors (6, 7) is enclosed by a casing (19) having an insulating inlet opening (21) for the current conductor (20) extending into the bushing (4), while the lightening arrester (18) is conductively connected to the casing jacket, and the casing jacket is conductively connected to the current conductor at a place situated between the current sensor (10) and the bushing (4).

5. A high voltage transformer according to one of the preceding claims, wherein lightening arresters (18) connected between the adjacent zone of the bushings and earth potential are associated with each of the external connectors (6, 7), characterized in that the zone of the bushing (4, 5) adjacent the external connector (6, 7) is enclosed by a casing (19) having an inlet opening (22) conductively connected to the casing jacket for the current conductor (20) extending into the bushing (4), while the lightening arrester (18) extends through an insulating bushing (24) in the casing jacket and is conductively connected to the current conductor (20) at a place situated between the current sensor (10) and the bushing (4).

## Revendications

1. Transformateur à haute tension présentant les caractéristiques suivantes :
- les bornes (2,3) de l'enroulement primaire et de l'enroulement secondaire sont raccordées respectivement par l'intermédiaire de traversées (4,5) à des points extérieurs de raccordement (6,7),
- des moyens de mesure (10,11,12) pour déterminer l'intensité du courant côté primaire et côté secondaire sont prédéterminés,
- les moyens de mesure sont associés à un dispositif d'exploitation (12) de telle sorte que, lorsque le rapport des intensités du courant ne correspond pas à l'inverse du rapport de transmission du transformateur, l'écart est utilisé pour déclencher des interrupteurs de puissance (8,9) branchés, sur le côté primaire et sur le côté secondaire, en amont du transformateur,
- les moyens de mesure pour déterminer les intensités de courant sont deux détecteurs électro-optiques de courant (10,11), qui sont disposés respectivement dans la zone des traversées (4,5), qui est voisine des points extérieurs de raccordement (6,7),
- le signal de sortie du détecteur électro-optique respectif de courant (10,11) peut être transmis au dispositif d'exploitation (12) au moyen de guides de lumière (14,15).

2. Transformateur à haute tension selon la revendication 1, caractérisé en ce que les guides de lumière (14,15) de chaque détecteur de courant (10,11) sont guidés à l'intérieur de la traversée associée (4,5), dans la zone située entre la traversée et la borne d'enroulement associée (2,3).

3. Transformateur à haute tension selon la revendication 1 ou 2, caractérisé en ce que d'autres transducteurs électro-optiques respectifs sont associés, en tant que détecteurs de tension, aux détecteurs de courant (10,11).

4. Transformateur à haute tension selon l'une des revendications précédentes, dans lequel des dispositifs (18) de dérivation des surtensions branchés respectivement entre la zone voisine des traversées et le potentiel de terre sont associés aux points extérieurs de raccordement (6,7), caractérisé en ce que la zone de la traversée (4,5), qui est voisine du point extérieur de raccordement (6,7), est entourée par un boîtier (19), qui possède une ouverture d'entrée isolante (21) pour le conducteur de courant (20) qui s'étend dans la traversée (4), le dispositif (18) de dérivation des surtensions étant relié de façon conductrice à l'enveloppe du boîtier, et l'enveloppe du boîtier étant reliée de façon conductrice au conducteur de courant, en un emplacement situé entre le détecteur de courant (10) et la traversée (4).

5. Transformateur à haute tension selon l'une des revendications précédentes, dans lequel des dispositifs (18) de dérivation des surtensions branchés respectivement entre la zone voisine des traversées et le potentiel de terre sont associés aux points extérieurs de raccordement (6,7), caractérisé en ce que la zone de la traversée (4,5), qui est voisine du point extérieur de raccordement (6,7), est entourée par un boîtier (19), qui possède une ouverture d'entrée (22), qui est reliée de façon conductrice à l'enveloppe du boîtier, pour le conducteur de courant (20) qui s'étend dans la traversée (4), le dispositif (18) de dérivation des surtensions étant guidé dans une traversée isolante (24) dans l'enveloppe du boîtier et étant relié de façon conductrice au conducteur de courant (20), en un emplacement situé entre le détecteur de courant (10) et la traversée (4).
